# EUROPEAN PATENT APPLICATION

(11) **EP 2 874 189 A2**
(43) Date of publication of application: **20.05.2015**
(21) Application number: 14191647.8
(22) Date of filing: 04.11.2014
(51) Int. Cl.: H01L 31/18

(54) **Scribing apparatus for manufacturing solar cells**

(30) Priority: 06.11.2013 KR 20130134298
(71) Applicant: Samsung SDI Co., Ltd., Yongin-si, Gyeonggi-do (KR)
(72) Inventor: Lee, Dong Ho, Gyeonggi-do (KR); Nam, Jung-Gyu, Gyeonggi-do (KR); Huh, Kwang-Soo, Gyeonggi-do (KR); Kim, Su-Jin, Gyeonggi-do (KR)
(74) Representative: Mounteney, Simon James

(57) **Abstract**

A scribing apparatus for manufacturing a solar cell, and a method of manufacturing a solar cell using the same are provided. The scribing apparatus includes a stage part configured to support a substrate having at least one thin film layer, a scribing unit configured to scribe on the at least one thin film layer, and a moving unit configured to move at least one of the stage part and the scribing unit during the scribing process. A method of manufacturing a solar cell using the scribing apparatus includes scribing a first pattern onto a reflective electrode layer using the scribing apparatus, the reflective electrode layer being on the substrate, the scribing apparatus further including a needle installation part having a first needle configured to scribe on one side of the reflective electrode layer, and a second needle configured to scribe on a side surface of the reflective electrode layer.

## Description

### BACKGROUND

### 1. Field

Aspects of the present invention relate to a scribing apparatus for manufacturing a solar cell or solar cells.

### 2. Description of the Related Art

Solar cells convert solar energy into electrical energy and generate electricity using two types of semiconductors: a P type semiconductor and an N type semiconductor. Solar cells may be primarily classified as a crystalline silicon solar cell which is used in most commercial products, a thin film solar cell which may include a chip substrate, or a combination of the crystalline silicon solar cell and the thin film solar cell.

Typically, thin film solar cells are manufactured by coating a film on a thin glass or plastic substrate. Generally, due to a characteristic of the thin film, the diffusion distance of a carrier (for example an intrinsic semiconductor layer) is much shorter than that of the crystalline structure. Therefore, in solar cells manufactured only to have a P-N junction structure, the collection efficiency of an electron-hole pair which is generated by the sunlight may be very low. Therefore, solar cells often have a P-I-N structure in which a light absorption layer formed of an intrinsic semiconductor having high light absorption characteristics is located between the P type semiconductor and the N type semiconductor.

Thin film solar cells generally have a structure in which a front transparent electrode layer, a light absorption layer, and a rear reflective electrode layer are positioned on a substrate in this order. With this structure, sunlight passes through the front transparent electrode layer to be absorbed onto the light absorption layer and any light which is not absorbed passes through the light absorption layer and is reflected from the rear reflective electrode layer for reabsorption.

In these examples, the front transparent electrode layer has a light receiving surface onto which the light is incident, for example a layer made from a transparent conductive material such as ZnO. In this example, as the area of the substrate is increased, loss of power generated due to the resistance of the transparent conductive material is also increased. Accordingly, the thin film solar cell according to these examples generally results in the loss of power generated due to the resistance of the transparent conductive material.

### SUMMARY

Aspects of the present invention relate to a scribing apparatus for manufacturing a solar cell or solar cells.

An aspect of the present invention relates to a scribing apparatus for manufacturing a solar cell or solar cells which is configured to shorten a process time (or tact time) for manufacturing the solar cell or solar cells.

Further aspects of the present invention relate to a scribing apparatus for manufacturing a solar cell or solar cells with minimized power loss otherwise caused by the resistance of a transparent conductive material of the solar cell or cells.

According to an embodiment of the present invention, a scribing apparatus for manufacturing a solar cell includes a stage part configured to support a substrate, the substrate comprising at least one thin film layer; a scribing unit configured to scribe on the at least one thin film layer on the substrate; and a moving unit configured to move at least one of the stage part and the scribing unit during the scribing process on the at least one thin film layer.

In an embodiment, the scribing unit may include a needle installation part including a first needle configured to scribe on one side of the at least one thin film layer on the substrate, and a second needle configured to scribe on a side surface of the at least one thin film layer created by a scribing line of the first needle.

In an embodiment, the first needle and the second needle may have a cylindrical or hexahedral shape, each having a thinned end portion in a direction away from the needle installation part.

In an embodiment, a cross-section of each end portion of the first needle and the second needle may polygonal or circular in shape.

In an embodiment, a needle opening may be defined in at least one of the first needle and the second needle of the scribing apparatus.

In an embodiment, the needle opening may be configured to supply an application material on the scribing line during scribing.

In an embodiment, the first needle and the second needle may each be movably coupled to the needle installation part.

In an embodiment, the scribing unit may further include a detecting unit in the needle installation part configured to monitor the first needle and the second needle.

According to another embodiment of the present invention, a method of manufacturing a solar cell using a scribing apparatus may include scribing a first pattern onto a reflective electrode layer using a scribing apparatus having a scribing unit, the reflective electrode layer being on a substrate supported on the scribing apparatus. The scribing apparatus may further include a stage part and a needle installation part, the needle installation part having a first needle configured to scribe on one side of the reflective electrode layer, and a second needle configured to scribe on a side surface of the reflective electrode layer created by a scribing line of the first needle. The method may further include placing a light absorption layer over the reflective electrode layer including the scribed first pattern on the substrate, placing a buffer layer over the light absorption layer, and placing a transparent electrode layer over the buffer layer.

In an embodiment, the method of manufacturing a solar cell using a scribing apparatus may further include laminating the transparent electrode layer, and scribing a second pattern and a third pattern through the transparent electrode layer, the buffer layer, and the light absorption layer. In this embodiment, the second pattern and the third pattern may be scribed simultaneously, and the scribing apparatus may further include a moving unit configured to move at least one of the stage part and the scribing unit during the scribing process along a first direction of scribing, and then along a second, perpendicular direction such that the scribing process can be repeated along a plurality of scribing lines.

In an embodiment, the method of manufacturing a solar cell using a scribing apparatus may further include applying an application material on the scribing line during scribing of the second pattern, the application material being supplied by a needle opening defined in at least one of the first needle and the second needle.

At least some of the above and other features of the invention are set out in the claims.

### BRIEF DESCRIPTION OF THE DRAWINGS

FIG. 1 is a diagram illustrating a solar cell manufacturing process according to a process of the related art.
FIG. 2 is a perspective view illustrating a scribing apparatus for manufacturing a solar cell according to an embodiment of the invention.
FIG. 3 is a top plan view illustrating a scribing apparatus for manufacturing a solar cell according to an embodiment of the invention.
FIG. 4 is a diagram illustrating an embodiment of a needle part of the scribing apparatus for manufacturing a solar cell according to an embodiment of the invention.
FIG. 5 is a diagram illustrating another embodiment of a needle part of the scribing apparatus for manufacturing a solar cell according to another embodiment of the invention.
FIG. 6 is a cross-sectional view illustrating a process of scribing and applying an application material using the scribing apparatus for manufacturing a solar cell according to an embodiment of the invention.
FIGS. 7 through 11 are diagrams illustrating use of the scribing apparatus for manufacturing a solar cell in stages according to an embodiment of the invention.

### DETAILED DESCRIPTION

The present invention is described more fully hereinafter with reference to the accompanying drawings, in which embodiments of the present invention are shown. As those skilled in the art would realize, the described embodiments may be modified in various ways, all without departing from the scope of the present invention.

Accordingly, the drawings and description are to be regarded as illustrative in nature and not restrictive. Like reference numerals designate like elements throughout the specification.

In addition, the size and thickness of each configuration shown in the drawings are arbitrarily shown for understanding and ease of description, but the present invention is not limited thereto.

In the drawings, the thickness of layers, films, panels, regions, etc., are exaggerated for clarity. In the drawings, for understanding and ease of description, the thickness of some layers and areas may be exaggerated. It will be understood by those skilled in the art that when an element such as a layer, film, region, or substrate is referred to as being "on" another element, it can be directly on the other element or intervening elements may also be present.

In addition, unless explicitly described to the contrary, the word "comprise" and variations such as "comprises" or "comprising," will be understood to imply the inclusion of stated elements but not the exclusion of any other elements. Further, in the specification, the word "on" means positioning on or below the object portion, but does not essentially mean positioning on the upper side of the object portion relative to the direction of gravity.

First, prior to describing a scribing apparatus 100 for manufacturing a solar cell or solar cells according to an embodiment of the present invention, a solar cell manufacturing process according to processes of the related art will be described.

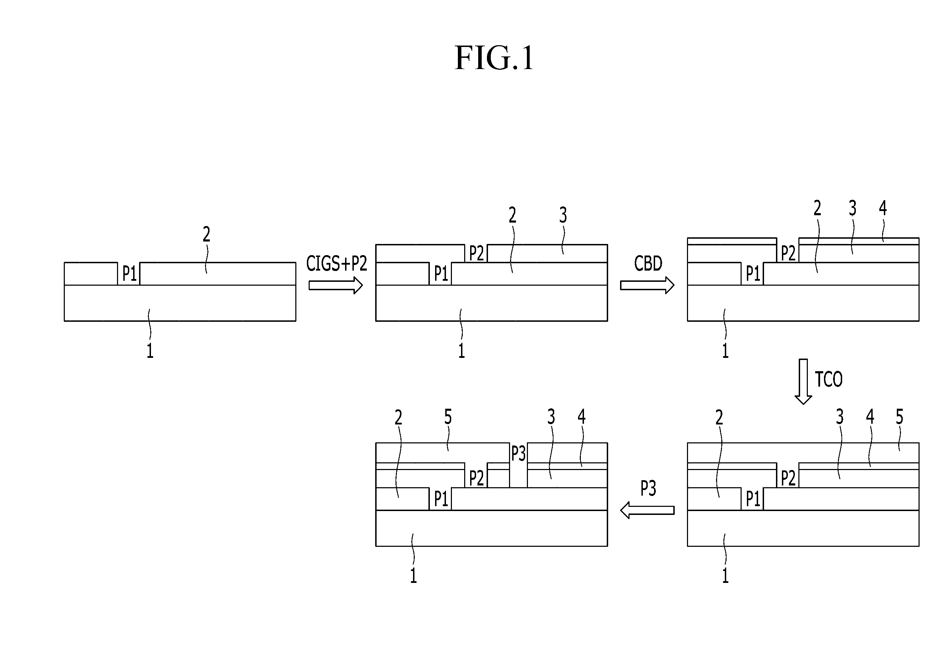

FIG. 1 is a diagram illustrating a solar cell manufacturing process according to a process of the related art.

Referring to FIG. 1, a solar cell manufacturing process of the related art includes the tasks of forming a first pattern P1 on a reflective electrode layer 2 formed above a substrate 1, forming a second pattern P2 on a light absorption layer 3 formed above the reflective electrode layer 2, forming a buffer layer 4 on a patterned light absorption layer 3, forming a transparent electrode layer 5 over the buffer layer 4, and forming a third pattern P3 on at least the transparent electrode layer 5.

In this related art example, the substrate 1 may be formed of a glass material. The reflective electrode layer 2 is formed of molybdenum (Mo) such that the reflective electrode layer 2 may be used as a positive (+) electrode.

The light absorption layer 3 may be a CIGS compound layer which includes copper (Cu), indium (In), gallium (Ga), and selenium (Se).

Further, the buffer layer 4 of this related art process may be formed of a material such as zinc sulfide (ZnS) or cadmium sulfide (CdS) deposited using a chemical bath deposition (CBD) process, and the transparent electrode layer 5 may be formed of a transparent conductive oxide (TCO) layer such as indium tin oxide (ITO) or aluminum zinc oxide (AZO) such that the transparent electrode layer 5 may be used as a negative (-) electrode.

According to the above-described related art, the transparent electrode layer 5 is deposited over the light absorption layer 3 (including the buffer layer 4) after scribing the second pattern P2 to form monolithic contact. In this example of the related art processes, there is often a high resistance between the transparent electrode layer 5 such that the reflective electrode layer 2 affects the flow of current.

Further, in the process of manufacturing a solar cell according to the related art, after forming the second pattern P2, a vacuum process for depositing the transparent electrode layer 5 is required, which may prolong the manufacturing time according to these related art processes.

Hereinafter, a scribing apparatus 100 for manufacturing a solar cell or cells according to an embodiment of the present invention will be described in more detail with reference to the drawings.

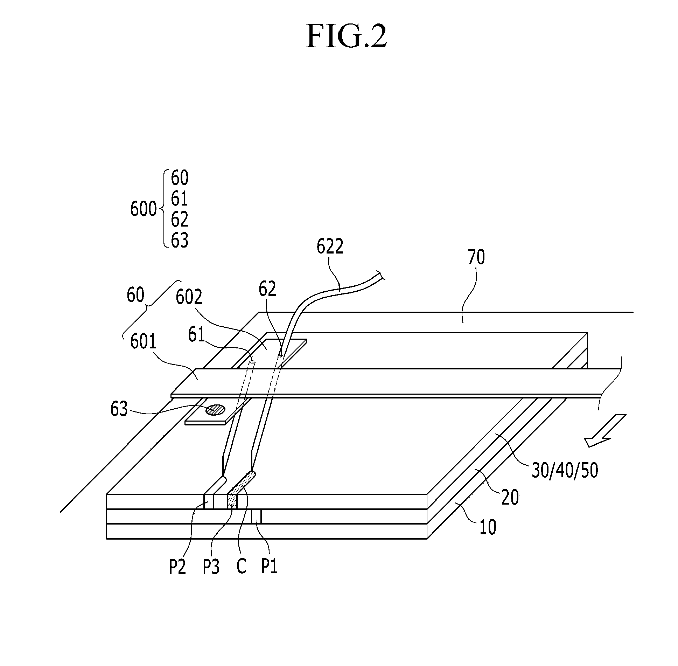

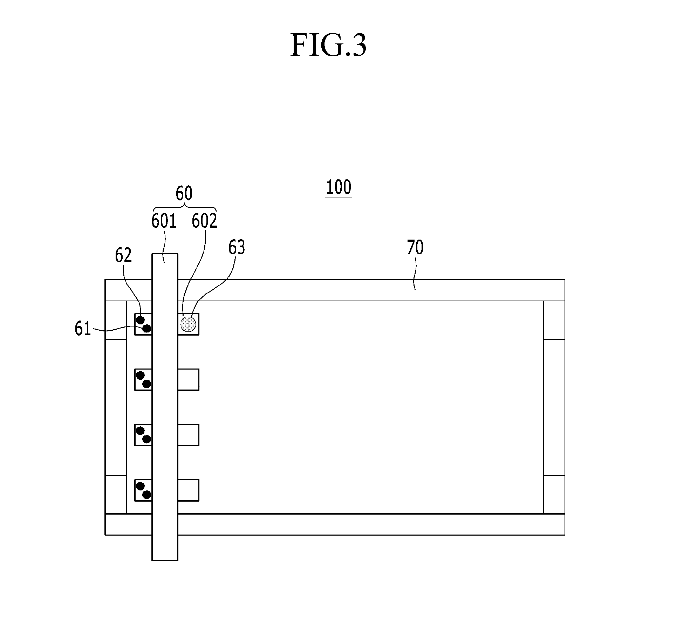

FIG. 2 is a perspective view illustrating a scribing apparatus 100 for manufacturing a solar cell according to an embodiment of the invention. FIG. 3 is a top plan view illustrating a scribing apparatus 100 for manufacturing a solar cell according to an embodiment of the invention.

Referring to FIGS. 2 and 3, a scribing apparatus 100 for manufacturing a solar cell according to an embodiment of the invention may include a stage part 70, a scribing unit 600, and a moving unit.

The stage part 70 of the scribing apparatus 100 according to this embodiment is configured to support a substrate 10.

In this embodiment, the substrate 10 is used during the manufacture of a solar cell or cells and may be formed of a glass, metal, or plastic material. A thin film may be placed on the substrate 10, and the thin film may include at least one thin film layer. For example, in an embodiment, the thin film may include at least one of a reflective electrode layer 20 on the substrate 10, a light absorption layer 30 on the reflective electrode layer 20, a buffer layer 40 on the light absorption layer 30, and a transparent electrode layer 50 on the buffer layer 40.

In this embodiment, the reflective electrode layer 20 may be a molybdenum (Mo) material such that the reflective electrode layer 20 may be used as a positive (+) electrode. The light absorption layer 30 according to this embodiment may be a CIGS compound layer which includes copper (Cu), indium (In), gallium (Ga), and selenium (Se).

The buffer layer 40 according to this embodiment may be a material such as zinc sulfide (ZnS) or cadmium sulfide (CdS), and the transparent electrode layer 50 may be a transparent conductive oxide (TCO) layer such as indium tin oxide (ITO) or aluminum zinc oxide (AZO) such that the transparent electrode layer 50 may be used as a negative (-) electrode.

The scribing apparatus 100 for manufacturing a solar cell according to this embodiment may perform a scribing process on at least one of the above-described thin film layers. Further, the scribing apparatus 100 according to this embodiment may simultaneously perform the scribing process on two or more thin film layers among the thin film layers.

Referring to FIGS. 2 and 3, the stage part 70 may support a bottom surface of the substrate 10.

The stage part 70 may be a quadrangular plate, but is not limited thereto, and may be modified to have any other shape which supports the substrate 10.

A scribing unit 600 of the scribing apparatus 100 according to the embodiment is configured to perform the scribing process on the thin film(s) on the substrate 10. For example, the scribing unit 600 may include a needle installation part 60, a first needle 61, a second needle 62, and a detecting unit 63.

In this embodiment, the needle installation part 60 of the scribing unit 600 may be movably coupled to the stage part 70. The stage part 70 may support the needle installation part 60 such that the first needle 61 and the second needle 62, described in further detail below, can be positioned for the scribing process to be performed on the thin film.

For example, in an embodiment, the needle installation part 60 may include a first needle installation part 601 and a second needle installation part 602. In this embodiment, the first needle installation part 601 may be configured such that both end portions thereof are coupled to a supporting member, which is movably coupled to each respective end portion of the stage part 70. Therefore, the first needle 61 and the second needle 62, described in further detail below, may move as the first needle installation part 601 and/or the stage part 70 move, according to this embodiment.

In this embodiment, one side of the second needle installation part 602 is coupled to the first needle installation part 601 where they intersect. In this embodiment, the second needle installation part 602 is coupled to the first needle installation part 601 and configured to move the first needle 61 and the second needle 62, which will be described in further detail below, to a region of the thin film on which the scribing process is performed.

The first needle 61 and the second needle 62 of the scribing unit 600, according to this embodiment, are positioned at one side of the second needle installation part 602, as illustrated in FIGS. 2 and 3.

In this embodiment, the first needle 61 and the second needle 62 are configured to perform the scribing process on a thin film on the substrate 10.

In an embodiment, as illustrated in FIGS. 2 and 3, the first needle 61 and the second needle 62 may be parallel to each other and perform the scribing process on one surface of the thin film and a side of the thin film where a scribing line is formed by the first needle 61.

In this embodiment, the first needle 61 and the second needle 62 may be formed of a material having a greater hardness number than the thin film, i.e., a material having a greater hardness number than the light absorption layer 30, the buffer layer 40, and the transparent electrode layer 50, configured to scribe the above thin films.

For example, in an embodiment, the first needle 61 and the second needle 62 may be Tungsten Carbide (WC) or made from a material having a hardness of approximately 9 Mohs or 1700 to 2400 Vickers Pyramid Number (HV).

In these embodiments, the first needle 61 and the second needle 62 may have a cylindrical shape or a polyhedral shape.

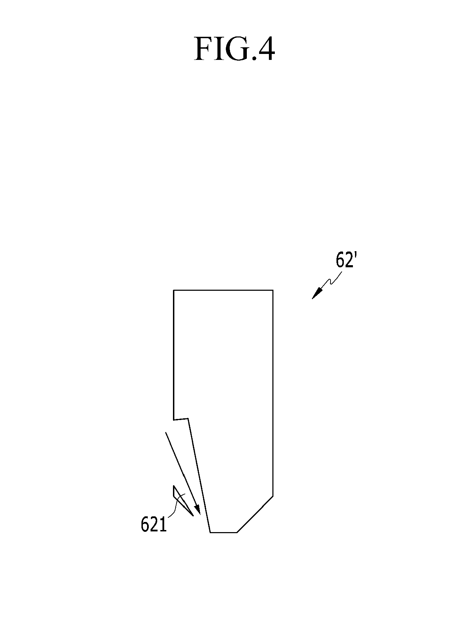

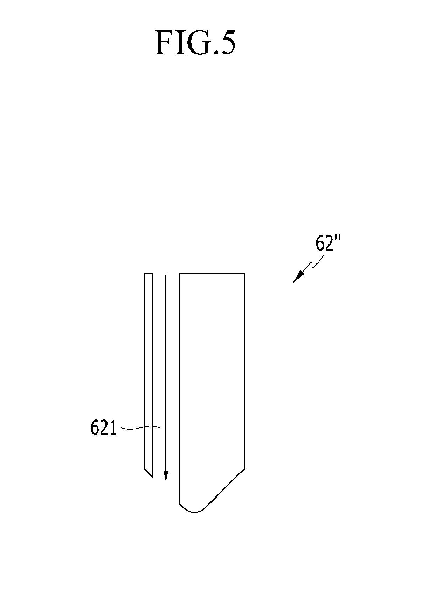

FIG. 4 is a diagram illustrating an embodiment of a needle part of the scribing apparatus 100 for manufacturing a solar cell according to an embodiment of the invention. FIG. 5 is a diagram illustrating another embodiment of a needle part of the scribing apparatus 100 for manufacturing a solar cell according to another embodiment of the invention.

Referring to the embodiments of FIGS. 4 and 5, an end (tip portion) of the second needle 62' and 62" which is opposite to the other end which is coupled to the second needle installation part becomes thinner toward the end portion.

In this embodiment, the end portion of the second needle 62' and 62" may have a shape with a cross-section that gradually thins and then flattens out, as illustrated in FIG. 4, or a cross-section that gradually thins with a rounded corner, as illustrated in FIG. 5.

Even though the shape of the needle is described with the second needles 62' and 62" as examples, the first needle 61 may be also have the same shape.

Further, referring to FIGS. 4 and 5, a needle opening 621 may be defined in the second needle 62' and 62".

In this embodiment, the needle opening 621 may be connected to an application material supplying line 622 (shown in FIG. 2) configured to supply an application material.

Referring to the embodiment of FIG. 2, even though the application material supplying line 622 may be connected only to the second needle 62, a needle opening 621 through which the application material supplying line 622 is connected may also be defined in the first needle 61 and/or the second needle 62.

Referring to the embodiments of FIGS. 4 and 5 again, the shape of the needle opening 621 may extend in a diagonal direction from a side of the second needle 62' as illustrated in FIG. 4, or may extend linearly from a rear of the second needle 62" as illustrated in FIG. 5.

Accordingly, a cross-section of the needle opening 621, according to these embodiments, may have an oval shape or a circular shape.

Even though the shape of the needle opening 621 is described with the second needles 62' and 62" as an example, the needle opening 621 having the same shape may also be defined in the first needle 61.

The needle opening 621, according to an embodiment, is not defined through the first needle 61 and/or the second needle 62, but may be defined in an application material supplying unit to which the application material supplying line 622 is connected.

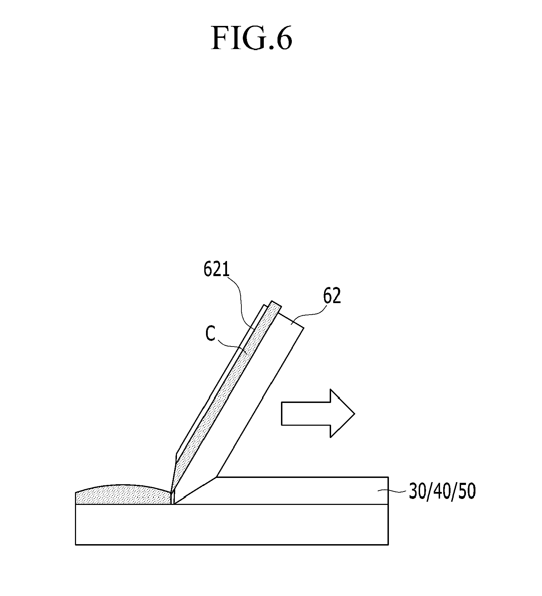

FIG. 6 is a cross-sectional view illustrating a process of scribing and applying an application material using the scribing apparatus 100 for manufacturing a solar cell according to an embodiment of the invention.

Referring to the embodiment of FIG. 6, the application material C is applied while performing the scribing process by the second needle 62 through which the needle opening 621 is defined.

More specifically, in this embodiment, when the second needle 62 is positioned in the second needle installation part, the end portion (tip portion) of the second needle 62 performs the scribing process on the thin film with the application material C being supplied through the needle opening 621 for application on the scribing line.

In this embodiment, the application material C may be a conductive material which contains silver or carbon, and in an embodiment, may be a material having a specific resistance lower than that of the transparent electrode layer 50. In an embodiment, the transparent electrode layer 50 has a specific resistance of approximately 10⁻³, and the application material C has a specific resistance lower than that in order to minimize the power loss due to the resistance of the transparent conductive material of the transparent electrode layer 50, i.e., the material of the application material C is a material having a high electric conductivity.

In an embodiment, the detecting unit 63 of the scribing unit 600 is configured to monitor the first needle 61 and the second needle 62.

Referring to FIGS. 2 and 3 again, the detecting unit 63 may be positioned at one side of the second needle installation part 602.

In an embodiment, the detecting unit 63 may be a camera or may be or use a sensor.

In an embodiment, a moving unit of the scribing apparatus 100 for manufacturing a solar cell may be configured to move the stage part 70 and/or the scribing unit 600. More specifically, in an embodiment, the moving unit may move the above-described stage part 70 and, particularly may move the needle installation part 60 in the scribing unit 600 or both the stage part 70 and the needle installation part 60. In embodiments where the moving unit moves both the stage part 70 and the needle installation part 60, the moving unit may move the stage part 70 and the needle installation part 60 in opposite directions from each other.

In these embodiments, as the moving unit moves the stage part 70 and/or the needle installation part 60, the first needle 61 and the second needle 62 may perform the scribing process on the thin film.

In an embodiment, when a direction of the scribing line is along the X-axis direction, for example, if the moving unit moves at least one of the stage part 70 and the needle installation part 60 to complete the scribing process for one scribing line, the moving unit may move at least one of the stage part 70 and the needle installation part 60 along the Y-axis direction which is perpendicular to the X-axis direction. By doing this, the scribing apparatus 100 for manufacturing a solar cell according to embodiments of the present invention may perform the scribing process on a plurality of scribing lines.

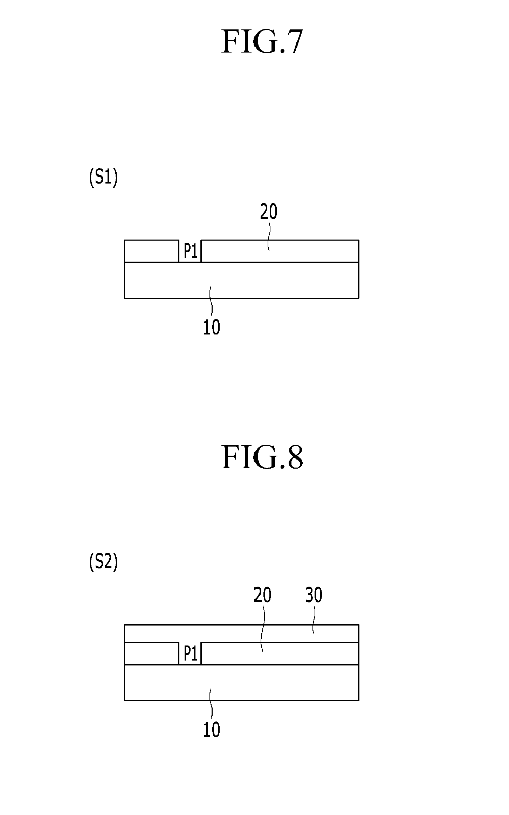

FIGS. 7 through 11 are diagrams illustrating use of the scribing apparatus 100 for manufacturing a solar cell in stages according to an embodiment of the invention.

First, referring to the embodiment of FIG. 7, a first pattern P1 is scribed S1 onto the reflective electrode layer 20 located on the substrate 10.

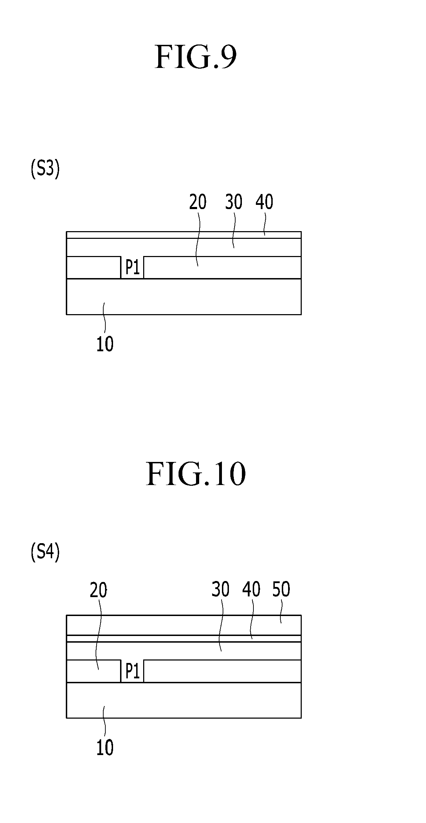

After the first pattern P1 is scribed S1 on the reflective electrode layer 20 (as illustrated in FIG. 7) according to this embodiment, the light absorption layer 30 is placed S2 over the reflective electrode layer 20 on which the first pattern P1 is scribed S1 (as shown in FIG. 8), and the buffer layer 40 and the transparent electrode layer 50 are sequentially placed S3 and S4, respectively, on the light absorption layer 30 (as shown in FIGS. 9 and 10, respectively).

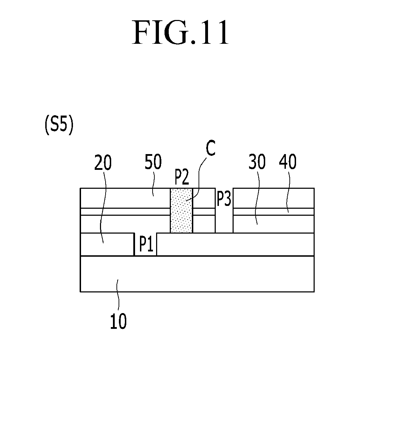

In these embodiments, the transparent electrode layer 50 is then completely laminated, as illustrated in FIG. 11, and a scribing process is performed S5 from the transparent electrode layer 50 through to the light absorption layer 30 above the reflective electrode layer 20 using the scribing apparatus 100 for manufacturing a solar cell according to the embodiments of the present invention to simultaneously scribe second and third patterns P2 and P3 applying the application material C inside the second pattern P2.

Even though the application material C is applied only at the second pattern P2 in the embodiment of FIG. 11, the present invention is not limited thereto.

Therefore, according to the embodiments of the scribing apparatus 100 for manufacturing a solar cell of the present invention, it is possible to shorten a process time (tact time) in a process of manufacturing a solar cell.

While this disclosure has been described in connection with what is presently considered to be practical embodiments thereof, it is to be understood that the invention is not limited to the disclosed embodiments, but, on the contrary, is intended to cover various modifications and equivalent arrangements included within the scope of the appended claims.

## Claims

1. A scribing apparatus for manufacturing a solar cell, comprising:
a stage part configured to support a substrate, the substrate comprising at least one thin film layer;
a scribing unit configured to scribe on the at least one thin film layer on the substrate; and
a moving unit configured to move at least one of the stage part and the scribing unit during the scribing process on the at least one thin film layer.

2. A scribing apparatus according to claim 1, wherein the scribing unit comprises:
a needle installation part comprising
a first needle configured to scribe on one side of the at least one thin film layer on the substrate, and
a second needle configured to scribe on a side surface of the at least one thin film layer created by a scribing line of the first needle.

3. A scribing apparatus according to claim 2, wherein the first needle and the second needle are cylindrical or hexahedral shaped, each having a thinned end portion in a direction away from the needle installation part.

4. A scribing apparatus according to claim 3, wherein a cross-section of each end portion of the first needle and the second needle is polygonal or circular in shape.

5. A scribing apparatus of claim 2, 3 or 4, wherein a needle opening is defined in at least one of the first needle and the second needle.

6. A scribing apparatus according to claim 5, wherein the or each needle opening is configured to supply an application material on the scribing line during scribing.

7. A scribing apparatus according to one of claims 2 to 6, wherein the first needle and the second needle are each movably coupled to the needle installation.

8. A scribing apparatus according to one of claims 2 to 7, wherein the scribing unit further comprises a detecting unit in the needle installation part configured to monitor the first needle and the second needle.

9. A method of manufacturing a solar cell using a scribing apparatus, the method comprising:
scribing a first pattern onto a reflective electrode layer using a scribing apparatus comprising a scribing unit, the reflective electrode layer being on a substrate supported on the scribing apparatus, the scribing apparatus further comprising a stage part and a needle installation part, the needle installation part comprising a first needle configured to scribe on one side of the reflective electrode layer, and a second needle configured to scribe on a side surface of the reflective electrode layer created by a scribing line of the first needle;
placing a light absorption layer over the reflective electrode layer including the scribed first pattern on the substrate,
placing a buffer layer over the light absorption layer, and
placing a transparent electrode layer over the buffer layer.

10. A method according to claim 9, further comprising:
laminating the transparent electrode layer, and
scribing a second pattern and a third pattern through the transparent electrode layer, the buffer layer, and the light absorption layer,
wherein the second pattern and the third pattern are scribed simultaneously, and
wherein the scribing apparatus further comprises a moving unit configured to move at least one of the stage part and the scribing unit during the scribing process along a first direction of scribing, and then along a second perpendicular direction such that the scribing process can be repeated along a plurality of scribing lines.

11. A method of claim 10, further comprising:
applying an application material on the scribing line during scribing of the second pattern, the application material being supplied by a needle opening defined in at least one of the first needle and the second needle.
